(19) Europäisches Patentamt
European Patent Office
Office européen des brevets

(11) **EP 4 482 284 A1**

(12) **EUROPEAN PATENT APPLICATION**
published in accordance with Art. 153(4) EPC

(43) Date of publication:
**25.12.2024 Bulletin 2024/52**

(21) Application number: **22925980.9**

(22) Date of filing: **14.02.2022**

(51) International Patent Classification (IPC):
**H10N 60/10** (2023.01)   **H10N 60/81** (2023.01)
**G06N 10/00** (2022.01)

(52) Cooperative Patent Classification (CPC):
**H10N 69/00; G06N 10/40; H01L 24/11; H01L 24/13;
H01L 24/14; H01L 24/16; H01L 24/81; H10N 60/81;
B82Y 10/00**

(86) International application number:
**PCT/JP2022/005649**

(87) International publication number:
**WO 2023/152961 (17.08.2023 Gazette 2023/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **FUJITSU LIMITED**
**Kawasaki-shi, Kanagawa 211-8588 (JP)**

(72) Inventors:
• **TAKENOUCHI, Masatoshi**
  **Kawasaki-shi, Kanagawa 211-8588 (JP)**
• **KOUMA, Norinao**
  **Kawasaki-shi, Kanagawa 211-8588 (JP)**
• **SHIMANOUCHI, Takeaki**
  **Kawasaki-shi, Kanagawa 211-8588 (JP)**
• **TAKAHASHI, Tsuyoshi**
  **Kawasaki-shi, Kanagawa 211-8588 (JP)**

(74) Representative: **Haseltine Lake Kempner LLP**
**Cheapside House**
**138 Cheapside**
**London EC2V 6BJ (GB)**

(54) **ELECTRONIC DEVICE AND METHOD FOR MANUFACTURING ELECTRONIC DEVICE**

(57)   A quantum operation device (10) includes a first substrate (30) including a circuit element and a second substrate (40) that is laminated on the first substrate (30) and covers the circuit element. The second substrate (40) includes a bump (42) including a tapered protrusion (44) that includes a base material (43) of the second substrate (40) and of which an area of a cross section intersecting with a lamination direction of the first substrate (30) and the second substrate (40) is gradually reduced toward a front end and tapered conductive films (45A and 45B) that cover a surface of the protrusion (44) and reflect a shape of the protrusion (44). The bump (42) is bonded to the first substrate (30).

FIG. 5

EP 4 482 284 A1

## Description

FIELD

The disclosed technology relates to an electronic device and a method for manufacturing the electronic device.

BACKGROUND

As a technique relating to a quantum operation device, the following techniques have been known. For example, a quantum computing device has been known that includes a substrate including Jozefson bonding and an interposer substrate bonded to the substrate via a bump.

Furthermore, a quantum device has been known that includes a plurality of protrusions provided on a surface of a quantum bit chip and a heat sink having a plurality of depressions arranged to fit into the plurality of protrusions.

Furthermore, a quantum device has been known that includes a substrate including a superconductor quantum device and a cap layer that is bonded to the above substrate so as to form a cavity sealed between the above substrate.

SUMMARY

TECHNICAL PROBLEM

In an electronic device formed by laminating a plurality of substrates, the substrates are bonded to each other by bonding a plurality of bumps provided on one substrate to a pad provided on another substrate. The plurality of bumps is deformed by applying a pressing force to press one substrate against the other substrate, and is crimped to the pad. However, in a case where heights of the bumps are uneven due to manufacturing variations, the pressing force is not applied to some bumps having a relatively low height, and there is a possibility that bonding failures occur in some bumps with the relatively low height.

An object of the disclosed technology is to prevent bonding failures of a bump, in an electronic device including a plurality of substrates bonded to each other via the bump.

SOLUTION TO PROBLEM

An electronic device according to the disclosed technology includes a first substrate that includes a circuit element and a second substrate that is laminated on the first substrate and covers the circuit element. One of the first substrate and the second substrate includes a bump bonded to another one of the first substrate and the second substrate. The bump includes a tapered protrusion that includes a base material of the substrate and of which an area of a cross section intersecting with a lamination direction of the first substrate and the second substrate is gradually reduced toward a front end. The bump includes a tapered conductive film that covers a surface of the protrusion and reflects a shape of the protrusion.

ADVANTAGEOUS EFFECTS OF INVENTION

According to the disclosed technology, in an electronic device including a plurality of substrates bonded to each other via a bump, it is possible to suppress bonding failures of the bumps.

BRIEF DESCRIPTION OF DRAWINGS

FIG. 1 is a partial equivalent circuit diagram of a quantum operation device according to an embodiment of the disclosed technology.
FIG. 2 is a diagram illustrating an example of a circuit configuration of a qubit element according to the embodiment of the disclosed technology.
FIG. 3 is a diagram illustrating an example of a coupling configuration between the qubit elements according to the embodiment of the disclosed technology.
FIG. 4 is a diagram illustrating an example of a circuit configuration of a resonator according to the embodiment of the disclosed technology.
FIG. 5 is a schematic cross-sectional view illustrating an example of a configuration of the quantum operation device according to the embodiment of the disclosed technology.
FIG. 6A is a plan view illustrating an example of a configuration of a second substrate according to the embodiment of the disclosed technology.
FIG. 6B is a cross-sectional view taken along 6B-6B in FIG. 6A.
FIG. 7 is a perspective view illustrating an example of a bump structure according to the embodiment of the disclosed technology.
FIG. 8A is a cross-sectional view illustrating an example of a method for bonding the bump and a pad according to the embodiment of the disclosed technology.
FIG. 8B is a cross-sectional view illustrating an example of the method for bonding the bump and the pad according to the embodiment of the disclosed technology.
FIG. 9 is a diagram of a modeled conical bump according to the embodiment of the disclosed technology.
FIG. 10 is a graph illustrating an example of a relationship between a pressing force to be applied to the bump and a height of the bump according to the embodiment of the disclosed technology.

FIG. 11A is a cross-sectional view illustrating an example of a method for manufacturing the second substrate according to the embodiment of the disclosed technology.

FIG. 11B is a cross-sectional view illustrating an example of the method for manufacturing the second substrate according to the embodiment of the disclosed technology.

FIG. 11C is a cross-sectional view illustrating an example of the method for manufacturing the second substrate according to the embodiment of the disclosed technology.

FIG. 11D is a cross-sectional view illustrating an example of the method for manufacturing the second substrate according to the embodiment of the disclosed technology.

FIG. 11E is a cross-sectional view illustrating an example of the method for manufacturing the second substrate according to the embodiment of the disclosed technology.

FIG. 11F is a cross-sectional view illustrating an example of the method for manufacturing the second substrate according to the embodiment of the disclosed technology.

FIG. 11G is a cross-sectional view illustrating an example of the method for manufacturing the second substrate according to the embodiment of the disclosed technology.

FIG. 11H is a cross-sectional view illustrating an example of the method for manufacturing the second substrate according to the embodiment of the disclosed technology.

FIG. 12A is a cross-sectional view illustrating an example of a method for manufacturing a first substrate according to the embodiment of the disclosed technology.

FIG. 12B is a cross-sectional view illustrating an example of the method for manufacturing the first substrate according to the embodiment of the disclosed technology.

FIG. 12C is a cross-sectional view illustrating an example of the method for manufacturing the first substrate according to the embodiment of the disclosed technology.

FIG. 12D is a cross-sectional view illustrating an example of the method for manufacturing the first substrate according to the embodiment of the disclosed technology.

FIG. 12E is a cross-sectional view illustrating an example of the method for manufacturing the first substrate according to the embodiment of the disclosed technology.

FIG. 12F is a cross-sectional view illustrating an example of the method for manufacturing the first substrate according to the embodiment of the disclosed technology.

FIG. 12G is a cross-sectional view illustrating an example of the method for manufacturing the first substrate according to the embodiment of the disclosed technology.

FIG. 13A is a cross-sectional view illustrating an example of a method for bonding the first substrate and the second substrate according to the embodiment of the disclosed technology.

FIG. 13B is a cross-sectional view illustrating an example of the method for bonding the first substrate and the second substrate according to the embodiment of the disclosed technology.

FIG. 14A is a cross-sectional view illustrating bonding between a bump and a pad according to a comparative example.

FIG. 14B is a cross-sectional view illustrating the bonding between the bump and the pad according to the comparative example.

FIG. 15 is a cross-sectional view illustrating an example of a method for forming the bump according to the comparative example.

FIG. 16A is a plan view illustrating an example of a configuration of a second substrate according to another embodiment of the disclosed technology.

FIG. 16B is a cross-sectional view taken along 16B-16B in FIG. 16A.

FIG. 17 is a cross-sectional view illustrating an example of a configuration of a quantum operation device according to the another embodiment of the disclosed technology.

DESCRIPTION OF EMBODIMENTS

An example of embodiments of the disclosed technology will be described below with reference to the drawings. Note that, in each drawing, the same or equivalent components and portions will be given the same reference signs, and redundant explanation will be omitted.

[First Embodiment]

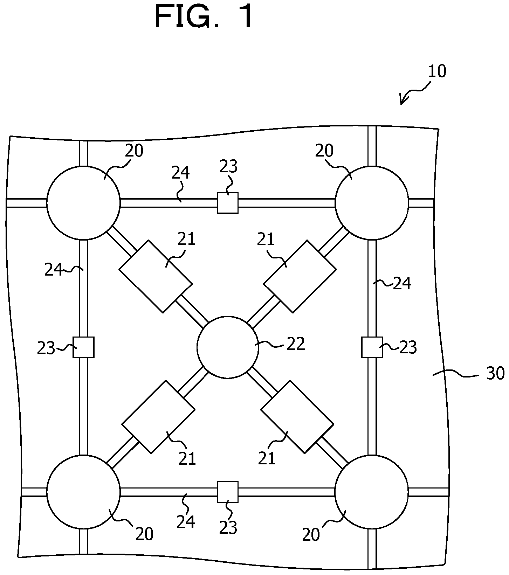

FIG. 1 is a plan view illustrating an example of a configuration of a quantum operation device 10 according to an embodiment of the disclosed technology. The quantum operation device 10 includes a qubit element (Qubit) 20, a resonator 21, and a reading electrode 22, provided on a first substrate 30. Note that the quantum operation device 10 is an example of an electronic device in the disclosed technology. The qubit element 20 and the resonator 21 are examples of a circuit element in the disclosed technology.

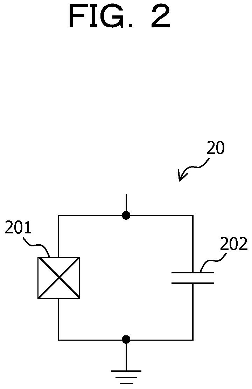

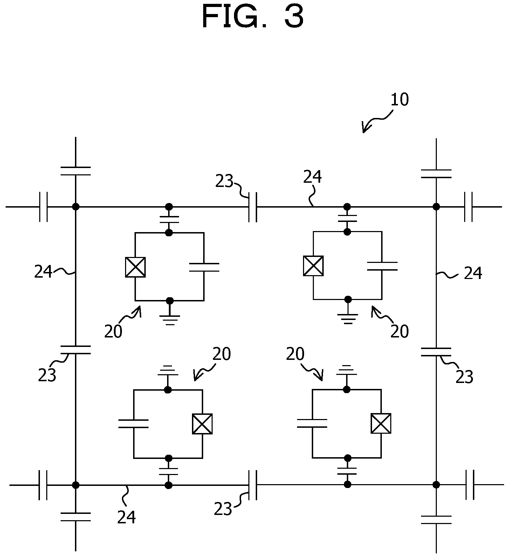

The qubit element 20 is an element that forms a coherent two-level system using superconductivity. FIG. 2 is a diagram illustrating an example of a circuit configuration of the qubit element 20. The qubit element 20 performs a quantum operation using nonlinear energy, and includes a transmon qubit circuit in which a superconducting Josephson device 201 and a capacitor 202 are coupled in parallel. The superconducting Josephson device 201 includes a pair of superconductors that exhibit superconductivity at a temperature equal to or lower than a predetermined critical temperature, and an ultrathin insulator having a thickness of about several nm sandwiched between the pair of superconductors. The superconductor may be, for example, aluminum, and the insulator may be, for example, aluminum oxide. As illustrated in FIG. 3, in the quantum operation device 10, the plurality of qubit elements 20 is coupled to other adjacent qubit elements 20 via an inter-bit wiring line 24. Capacitors 23 are provided in a path of the inter-bit wiring line 24. As a result, each of the qubit elements 20 creates a quantum entanglement state with the other adjacent qubit elements 20 and performs the quantum operation.

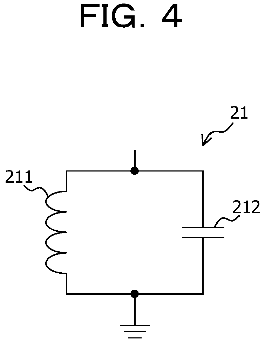

The resonator 21 interacts with the qubit element 20 to read a bit signal indicating a state of the qubit element 20. The resonator 21 is coupled to the qubit element 20 via a capacitor (not illustrated). FIG. 4 is a diagram illustrating an example of a circuit configuration of the resonator 21. The resonator 21 includes a resonance circuit in which a superconducting inductor 211 and a capacitor 212 are coupled in parallel. The reading electrode 22 is an electrode that is coupled to the resonator 21 and extracts the bit signal read by the resonator 21 to outside.

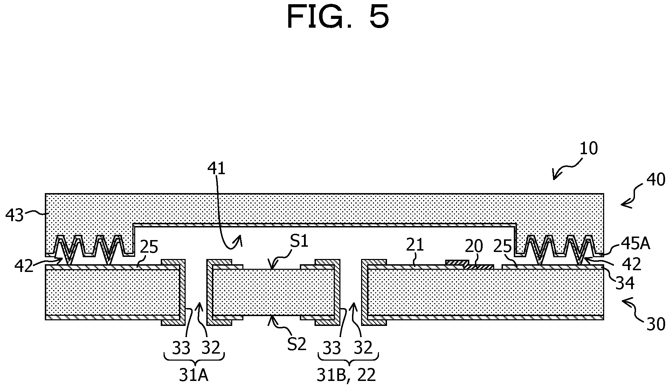

FIG. 5 is a schematic cross-sectional view illustrating an example of the configuration of the quantum operation device 10. Note that, FIG. 5 extracts and illustrates only periphery configurations of the single qubit element 20. The quantum operation device 10 includes the first substrate 30 and a second substrate 40 that are laminated.

On a first surface S1 of the first substrate 30, the qubit element 20 and the resonator 21 are provided. Through-vias 31A and 31B are provided in the first substrate 30. Each of the through-vias 31A and 31B includes a through-hole 32 that passes through the first substrate 30 and a conductive film 33 that covers an inner wall of the through-hole 32. The conductive film 33 includes portions extending to the first surface S1 of the first substrate 30 and a second surface S2 on an opposite side to the first surface S1. The through-via 31A is used to supply a ground potential to the first substrate 30 and the second substrate 40. The through-via 31B functions as the reading electrode 22.

As a base material of the first substrate 30, an insulator or a semiconductor can be used, and for example, silicon can be suitably used. On a surface of the first substrate 30, a conductive film 34 configuring a pad 25 and other wiring lines is provided. The resonator 21 may include this conductive film 34. The pad 25 is electrically coupled to the through-via 31A, and the ground potential is supplied from outside via the through-via 31A.

It is preferable that each of the conductive film 33 forming the through-vias 31A and 31B and the conductive film 34 configuring the pad 25 and the other wiring lines be formed of metal that exhibits superconductivity at a temperature equal to or lower than a predetermined temperature. As a material of the conductive film 34 configuring the pad 25 and the other wiring lines, for example, titanium nitride (TiN) can be suitably used. As a material of the conductive film 33 forming the through-vias 31A and 31B, for example, aluminum (Al) can be suitably used.

The second substrate 40 is laminated on a side of the first surface S1 of the first substrate 30. The second substrate 40 functions as a cover that covers the qubit element 20 and the resonator 21. The second substrate 40 includes a cavity 41 on a surface facing the first surface S1 of the first substrate 30, and a space is formed around the qubit element 20 and the resonator 21. The second substrate 40 includes a plurality of bumps 42 provided on an outer periphery of the cavity 41, and the plurality of bumps 42 is bonded to the pad 25 provided on the first substrate 30. Note that, in a case where it is possible to form a gap between the first substrate 30 and the second substrate 40, it is not necessary to provide the cavity 41 on the second substrate 40.

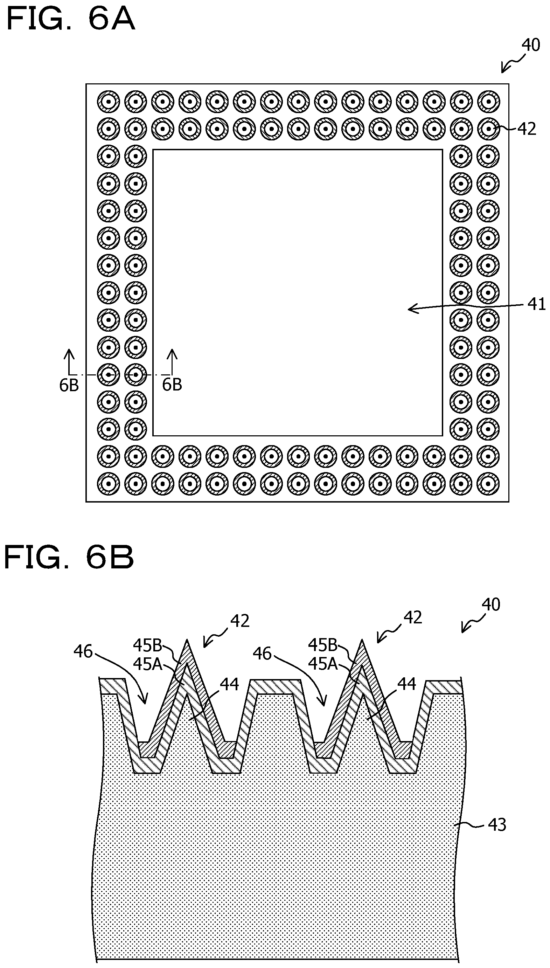

FIG. 6A is a plan view illustrating an example of a configuration of the second substrate 40. FIG. 6B is a cross-sectional view taken along 6B-6B in FIG. 6A. The plurality of bumps 42 is arranged in a plurality of lines so as to surround the cavity 41. Each of the plurality of bumps 42 includes a plurality of protrusions 44 including a base material 43 of the second substrate 40 and conductive films 45A and 45B that cover a surface of each of the plurality of protrusions 44. The protrusion 44 is formed by micromachining the base material 43, by etching. Regarding the protrusion 44, an area of a cross section intersecting with a lamination direction of the first substrate 30 and the second substrate 40 (that is, height direction of bump 42) is gradually reduced toward a front end of the bump 42. That is, the protrusion 44 has a tapered shape. The protrusion 44 is a portion to be a core of the bump 42.

The conductive film 45A covers an entire surface of the second substrate 40 facing the first substrate 30, including the surface of the protrusion 44. The conductive film 45B covers a surface of the conductive film 45A, in a formation region of the protrusion 44 of the second substrate 40. Portions of the conductive films 45A and 45B covering the protrusion 44 form the bumps 42. The portion of the conductive films 45A and 45B covering the protrusion 44 has a tapered shape reflecting the shape of the protrusion 44. The front end of the bump 42 protrudes from the surface of the base material 43, and when the second substrate 40 is stacked on the first substrate 30 in a process for bonding the second substrate 40 to the first substrate 30, the front end of the bump 42 is brought into contact with the first substrate 30.

It is preferable that each of the conductive films 45A and 45B be formed of metal that exhibits superconductivity at the temperature equal to or lower than the predetermined temperature. As a material of the conductive film 45A, for example, titanium nitride (TiN) can be suitably used. As a material of the conductive film 45B, for example, indium (In) can be suitably used. As the base material 43 of the second substrate 40, an insulator or a semiconductor can be used, and for example, silicon can be suitably used. In a case where the base material 43 includes, for example, silicon, the protrusion 44 that forms the portion to be the core of the bump 42 includes silicon.

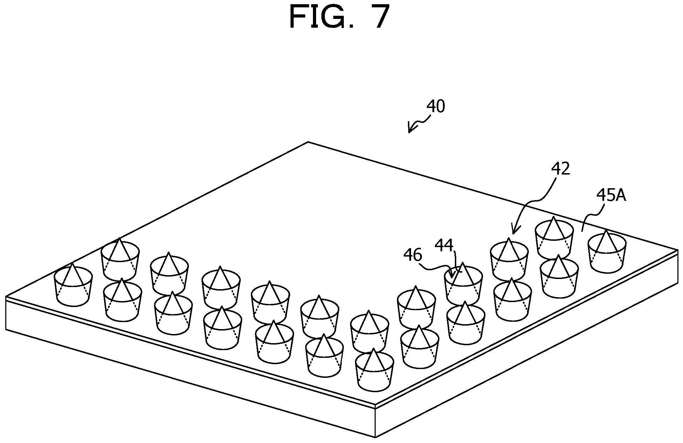

FIG. 7 is a perspective view illustrating an example of a structure of the bump 42. As illustrated in FIG. 7, the plurality of bumps 42 may have a conical shape. That is, the protrusion 44 formed on the base material 43 of the second substrate 40 may have a plurality of anchor structure portions. The plurality of bumps 42 may have a pyramid shape such as a triangular pyramid or a quadrangular pyramid.

The base material 43 of the second substrate 40 has a plurality of recesses 46 provided around each protrusion 44. The plurality of recesses 46 is provided respectively corresponding to the plurality of protrusions 44. Each of the recesses 46 surrounds an outer periphery of the corresponding protrusion 44. In other words, each protrusion 44 is provided inside of the corresponding recess 46. As will be described later, the recess 46 is formed by etching a region corresponding to the periphery of the protrusion 44 of the base material 43 of the second substrate 40. The protrusion 44 corresponds to a remaining portion of the base material 43 without being etched, in etching for forming the recess 46.

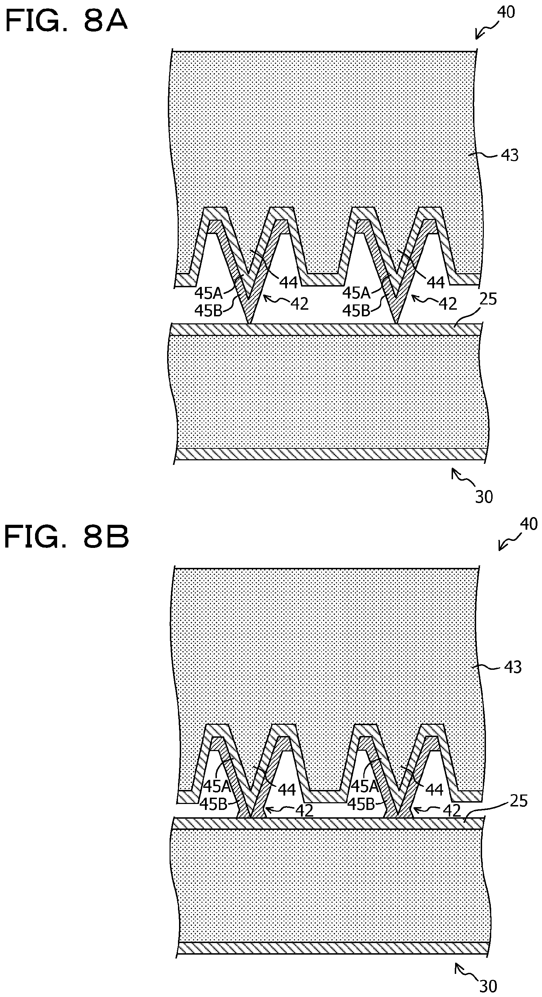

FIGs. 8A and 8B are cross-sectional views illustrating an example of a method for bonding the bump 42 provided on the second substrate 40 and the pad 25 provided on the first substrate 30. As illustrated in FIG. 8A, the front end of the bump 42 (conductive film 45B) is bonded to the pad 25. By applying the pressing force (load) to pressing the first substrate 30 and the second substrate 40 against each other, in a state where the front end of the tapered bump 42 is brought into contact with the pad 25, as illustrated in FIG. 8B, the front end of the bump 42, that is, the conductive film 45B is deformed to be crushed, and the bump 42 and the pad 25 are crimped. It is preferable to bond the bump 42 to the pad 25 at room temperature. By bonding the bump 42 to the pad 25, the ground potential is supplied to the conductive film 45A that covers the surface of the second substrate 40. By covering the qubit element 20 and the resonator 21 with the second substrate 40 fixed to the ground potential, it is possible to suppress exogenous noise that affects an operation of these circuit elements, and it is possible to suppress diffusion of electromagnetic noise radiated from these circuit elements.

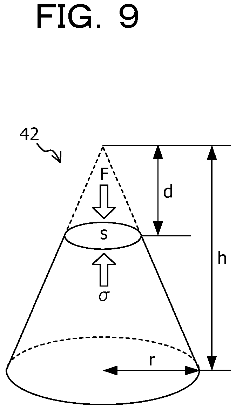

FIG. 9 is a diagram of the modeled conical bump 42. As illustrated in FIG. 9, a radius of a bottom surface of the bump 42 is set to r, and a height of the bump 42 is set to h. Furthermore, a stress acting on the bump 42 when a pressing force F is applied to the bump 42 is set to $\sigma$, a crushing amount of the bump 42 is set to d, and a cross-sectional area of a crushed front end portion of the bump 42 is set to S. In this case, the stress $\sigma$ can be expressed by the following formula (1), and the pressing force F can be expressed by the following formula (2).

$$\sigma = F/S \ ... \ (1)$$

$$F = \sigma \pi \ (dr/h)^2 \ ... \ (2)$$

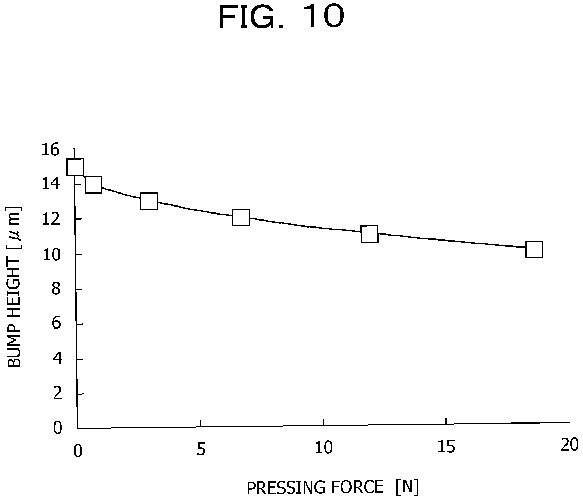

The above formulae (1) and (2) indicate that the pressing force F necessary for deforming the bump 42 so that a predetermined crushing amount d is realized can be reduced, as the height of the bump 42 is higher, or as the cross-sectional area S of the front end of the bump 42 is smaller. FIG. 10 is a graph illustrating an example of a relationship between the pressing force F to be applied to the bump 42 and the height h of the bump 42, in a case where the bump 42 is deformed so that the crushing amount d of the bump 42 is zero to 10 um. Note that it is estimated as setting an initial height of the bump 42 to 15 pm, setting the radius r of the bottom surface of the bump 42 to five um, and setting the stress $\sigma$ to 2.14 MPa. As illustrated in FIG. 10, as the cross-sectional area S increases with a progress of the deformation of the bump 42, the pressing force F necessary for deforming the bump 42 increases.

Since the bump 42 has a tapered shape, an area of the front end of the bump 42 can be reduced. As a result, a relatively small pressing force can deform the bump 42 with a large crushing amount. By increasing the crushing amount of the bump 42, even in a case where the heights of the bumps 42 are uneven due to manufacturing variations, it is possible to apply the pressing force (load) to all the bumps 42. That is, it is possible to reduce a risk of occurrence of bonding failures in some bumps with a relatively low height.

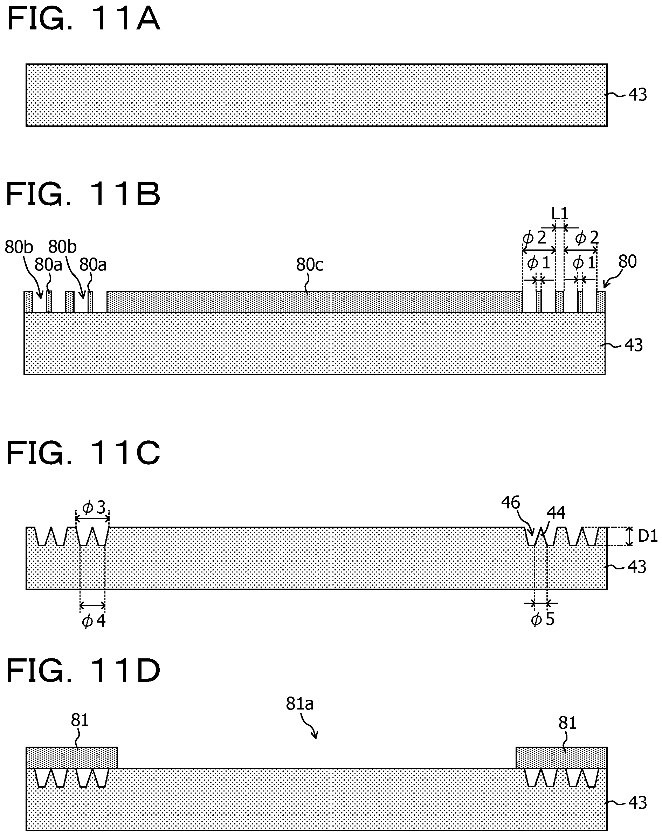

Hereinafter, a method for manufacturing the quantum operation device 10 will be described. First, an example of the method for manufacturing the second substrate 40 will be described with reference to FIGs. 11A to 11H.

The base material 43 of the second substrate 40 is prepared. A silicon substrate having a thickness of about 525 um can be suitably used as the base material 43 (FIG. 11A).

Next, a resist 80 having a thickness of about five um is formed on the surface of the base material 43. Next, by executing exposure and development processing on the resist 80, patterning corresponding to the bump 42 is performed on the resist 80 (FIG. 11B). Here, a case where the bump 42 having a conical shape is formed is indicated. A circular mask 80a having a diameter $\varphi 1$ is formed in a portion corresponding to the protrusion 44, and an annular opening 200b having a diameter $\varphi 2$ corresponding to the recess 46 is formed so as to surround a periphery of the mask 80a. The diameter $\varphi 1$ is, for example, about 15 um, and the diameter $\varphi 2$ is, for example, about 30 um. A distance L1 between the openings 80b adjacent to each other is, for example, 25 um. An inner peripheral portion of the surface of the base material 43 is covered with a mask 80c.

Next, the base material 43 is etched by using an inductively coupled plasma (ICP) etching device (FIG. 11C). It is preferable to set ICP power to be equal to or less than 2000 W, RF bias power to be equal to or less than 35 W, a chamber pressure to be equal to or less than 60 mTorr, and a gas ratio (C4F8: SF6) to 3: 7. As a result, a portion of the base material 43 exposed from the opening 80b of the resist 80 is etched, the plurality of annular recesses 46 is formed, and the protrusion 44 is formed inside of the recess 46. The protrusion 44 is a remaining portion of the base material 43 without being etched. By performing etching under the above conditions, a diameter $\varphi3$ at an upper end of the recess 46 is larger than a diameter $\varphi4$ at a lower end. That is, the recess 46 having the tapered shape is formed. As a result, a shape of the protrusion 44 is a conical shape. The diameter $\varphi3$ at the upper end of the recess 46 is about 40 um, and the diameter $\varphi4$ at the lower end of the recess 46 is about 30 um. A depth D1 of the recess 46 is about 15 um. A diameter $\varphi5$ at a lower end of the protrusion 44 is about 10 um.

Next, a dry film 81 is formed on the surface of the base material 43. Subsequently, by executing the exposure and development processing on the dry film 81, an opening 81a corresponding to the cavity 41 is formed in the dry film 81 (FIG. 11D).

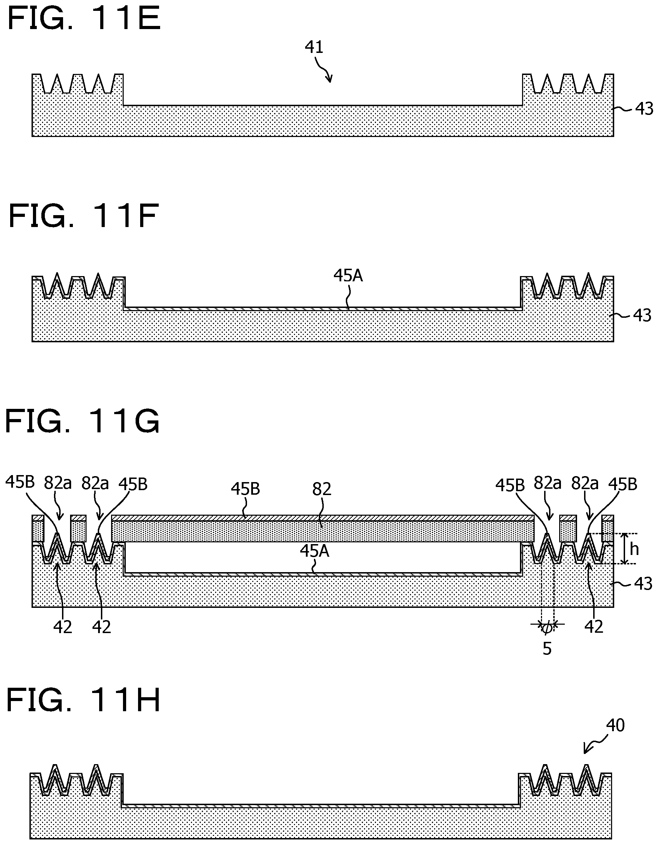

Next, by etching a portion of the base material 43 exposed from the opening 81a of the dry film 81, the cavity 41 having a depth of about 300 $\mu$m is formed in the base material 43 (FIG. 11E). The etching of the base material 43 can be performed by reactive ion etching (RIE). In this etching process, a step for covering a side surface of the cavity 41 being formed with a protection film and a step for further etching a bottom surface of the cavity 41 being formed are alternately performed. By covering the side surface of the cavity 41 with the protection film, etching of the side surface of the cavity 41 is suppressed, in the etching of the bottom surface of the cavity 41. CF gas is used in the step for covering the side surface of the cavity 41 with the protection film, and SF6 gas is used in the step for etching the bottom surface of the cavity 41. After the formation of the cavity 41 has been completed, the dry film 81 is removed.

Next, the conductive film 45A having a thickness of about 0.2 $\mu$m is formed on the entire surface of the base material 43 by a sputtering method (FIG. 11F). As a material of the conductive film 45A, titanium nitride (TiN) can be suitably used.

Next, a dry film 82 is formed on the surface of the base material 43. Subsequently, by executing the exposure and development processing on the dry film 82, an opening 82a corresponding to the bump 42 is formed in the dry film 82 (FIG. 11G). The opening 82a has a circular shape having a diameter of about 30 $\mu$m and is formed at a position where the bump 42 is formed.

Next, the conductive film 45B having a thickness of about 25 $\mu$m is formed in a portion of the surface of the conductive film 45A exposed from the opening 82a of the dry film 82, by a vapor deposition method (FIG. 11G). The conductive film 45B is also formed on the dry film 82. As a material of the conductive film 45B, indium (In) can be suitably used. The conductive films 45A and 45B are formed along a surface shape of the base material 43, and are formed in a conical shape reflecting the shape of the protrusion 44 in a portion covering the protrusion 44. On the second substrate 40, the conical bump 42 in which the protrusion 44, the conductive film 45A, and the conductive film 45B are laminated is formed. The diameter $\varphi5$ of the bottom surface of the bump 42 is about 10 $\mu$m, and the height h of the bump 42 is about 25 $\mu$m. That is, an aspect ratio (H/cp5) of the bump 42 is 2.5 (= 25/10). Next, the dry film 82 is removed together with the conductive film 45B deposited on its surface (FIG. 11H). Through each process described above, the second substrate 40 is completed.

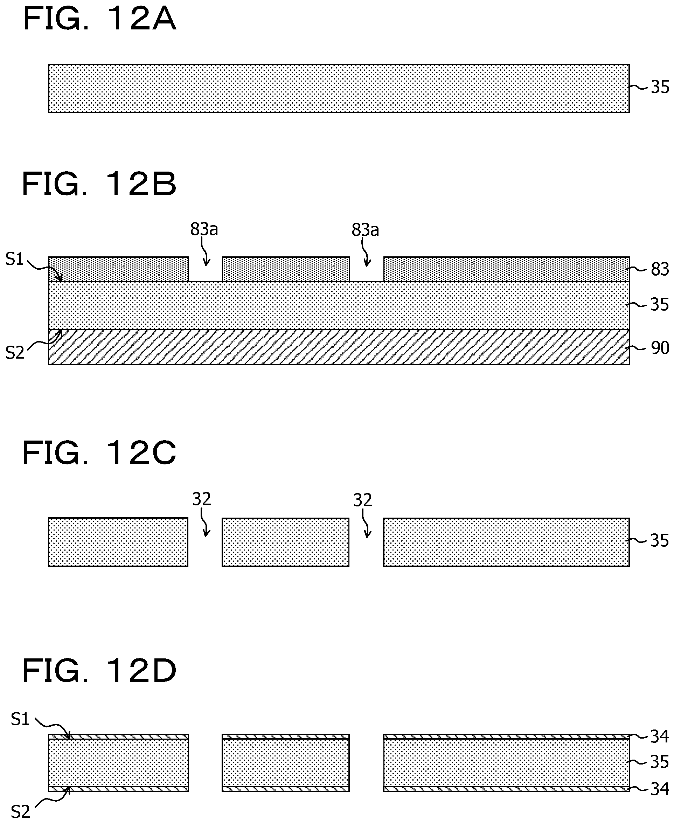

Hereinafter, an example of a method for manufacturing the first substrate 30 will be described with reference to FIGs. 12A to 12G. A base material 35 of the first substrate 30 is prepared. A silicon substrate having a thickness of about 525 $\mu$m can be suitably used as the base material 35 (FIG. 12A).

Next, a heat dissipation substrate 90 is attached to a second surface S2 of the base material 35. Subsequently, a resist 83 is formed on a first surface S 1 of the base material 35, and openings 83a corresponding to the through-vias 31A and 31B are formed in the resist 83 (FIG. 12B).

Next, a portion of the base material 35 exposed from the opening 83a of the resist 83 is etched to form the through-hole 32 in the base material 35 (FIG. 12C). Heat generated at the time of etching is diffused by the heat dissipation substrate 90, and an excessive increase in a temperature of the base material 35 is avoided.

Next, the conductive film 34 is formed on the entire first surface S1 and second surface S2 of the base material 35, by the sputtering method (FIG. 12D). As a material of the conductive film 34, titanium nitride (TiN) can be suitably used.

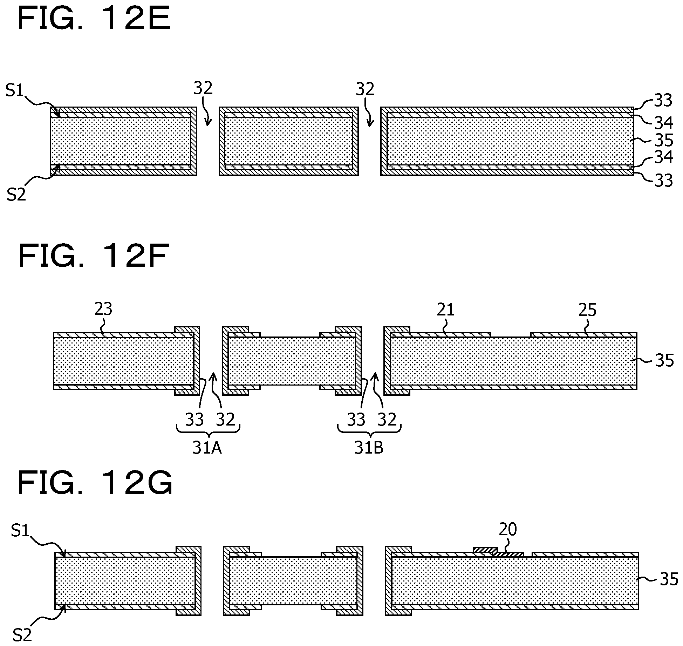

Next, the conductive film 33 is formed on the entire first surface S1 and second surface S2 of the base material 35, by the vapor deposition method. The conductive film 34 formed in advance is covered with the conductive film 33. The conductive film 33 is also formed on the inner wall of the through-hole 32 (FIG. 12E). As a material of the conductive film 33, aluminum (Al) can be suitably used.

Next, the conductive films 33 and 34 are patterned, by photolithography and etching. As a result, the through-vias 31A and 31B, the resonator 21, the pad 25, and the other wiring lines are formed (FIG. 12F).

Next, the qubit element 20 is formed on the first surface S1 of the base material 35 (FIG. 12G). The superconducting Josephson device constituting the qubit element 20 is formed by undergoing, for example, a process of forming a first electrode (not illustrated) containing aluminum (Al) on the first surface S1 of the base material 35 by the vapor deposition method, a process of forming an ultrathin oxide film (not illustrated) having a thickness of about several nm on a surface of the first electrode, using an $O_2$ gas, and a process of forming a second electrode (not illustrated) containing aluminum (Al) on a surface of the oxide film by the vapor deposition method. Patterning for the first electrode and the second electrode may be performed by, for example, a lift-off method using a patterned resist (not illustrated). In this case, an opening pattern of the resist may have a cross shape including a first straight line portion along a first direction and a second straight line portion along a second direction orthogonal to the first direction, and the first electrode may be formed at a portion corresponding to the first straight line portion by performing vapor deposition while performing inclination about the first direction as a rotation axis. Subsequently, the second electrode may be formed at a portion corresponding to the second straight line portion by performing vapor deposition while performing inclination about the second direction as a rotation axis. According to the above method, patterning for the first electrode and the second electrode can be performed with a single resist. Through each process described above, the first substrate 30 is completed.

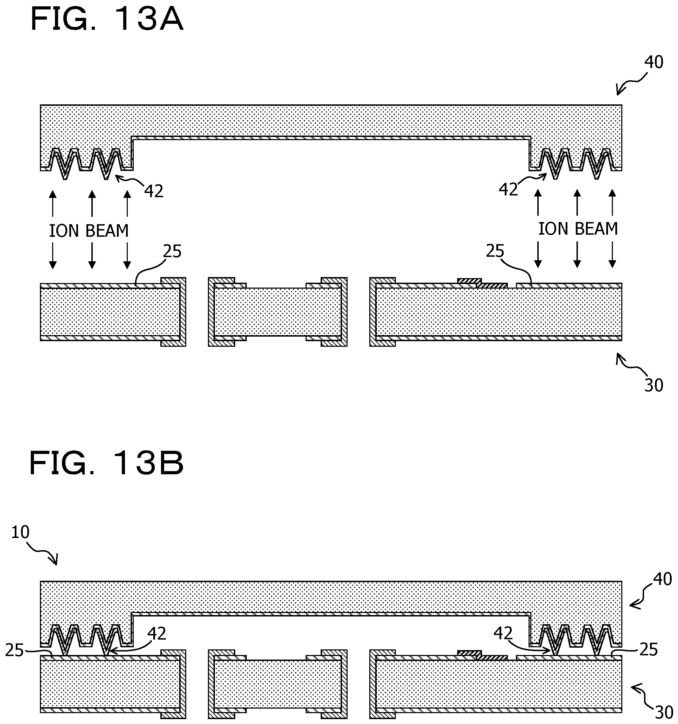

Hereinafter, a process for bonding the first substrate 30 and the second substrate 40 will be described with reference to FIGs. 13A and 13B.

The first substrate 30 and the second substrate 40 are housed in a vacuum chamber (not illustrated), and a bonding surface of the first substrate 30 and the second substrate 40 is irradiated with an ion beam in the vacuum chamber (FIG. 13A). As a result, elements that hinder bonding such as an oxide film, a hydroxyl group, or water molecules, existing on the surfaces of the pad 25 and the bump 42 forming a bonding portion are removed, and the surface of the conductive film forming the pad 25 and the bump 42 is activated. Inert gas such as argon is used for the ion beam.

Next, the first substrate 30 and the second substrate 40 are bonded in the vacuum chamber. That is, in a state where the bump 42 provided on the second substrate 40 and the pad 25 provided on the first substrate 30 are brought into contact with each other, a pressing force (load) for pressing the first substrate 30 and the second substrate 40 against each other is applied. As a result, the front end of the bump 42 (conductive film 45B) is deformed to be crushed, and the bump 42 and the pad 25 are bonded. It is preferable to bond the bump 42 to the pad 25 at room temperature. Since the surface of the conductive film forming the bump 42 and the pad 25 is activated by irradiation of the ion beam, strong bonding can be obtained at room temperature (about 25°C). This approach is called surface-activated room-temperature bonding. By bonding the substrates to each other at room temperature, characteristic fluctuations associated with heating of the qubit element 20 are suppressed. Through each process described above, the quantum operation device 10 is completed.

As described above, the quantum operation device 10 according to the present embodiment includes the first substrate 30 on which the circuit elements such as the qubit element 20 or the resonator 21 are provided and the second substrate 40 that is laminated on the first substrate 30 and covers the qubit element 20 and the resonator 21. The second substrate 40 includes the base material 43, and includes the bump 42 including the tapered protrusion 44 of which the area of the cross section intersecting with the lamination direction of the substrate is gradually reduced toward the front end, the tapered conductive films 45A and 45B that cover the surface of the protrusion 44 and reflect the shape of the protrusion 44. The bump 42 is bonded to the pad 25 on the first substrate 30.

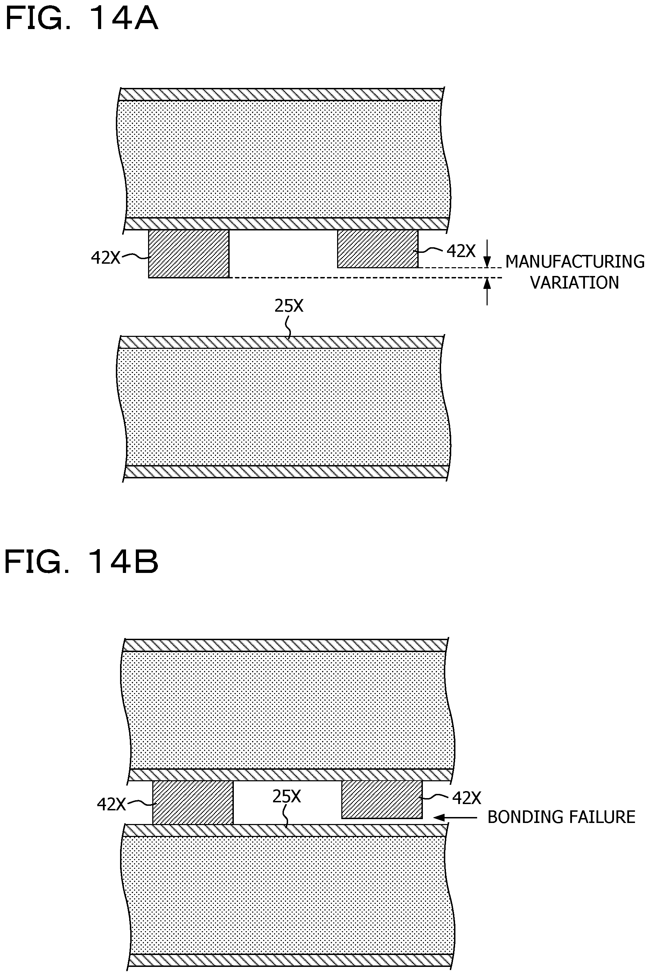

Here, FIGs. 14A and 14B are cross-sectional views illustrating bonding between a bump 42X and a pad 25X according to a comparative example. In a shape of the bump 42X according to the comparative example, an area of a cross section intersecting with a height direction is larger than the bump 42 according to the first embodiment, and a height of the bump is substantially constant. That is, the shape of the bump 42X is not a tapered shape. Furthermore, the heights of the bumps 42X are uneven, due to manufacturing variations. In a process for bonding the bump 42X to the pad 25X, the pressing force is applied in a state where the bump 42X and the pad 25X are brought into contact with each other. Regarding the bump 42X according to the comparative example, since the area of the cross section intersecting with the height direction is relatively large, a crushing amount of the bump 42X with respect to a predetermined pressing force decreases. In a case where the crushing amount of the bump 42X is small, as illustrated in FIG. 14B, the pressing force is not applied to some of the bumps 42X having a relatively low height, and there is a possibility that bonding failures occur in some of the bumps 42X having the relatively low height.

On the other hand, since the bump 42 included in the quantum operation device 10 according to the embodiment of the disclosed technology has a tapered shape, the area of the front end of the bump 42 can be reduced. As a result, a relatively small pressing force can deform the bump 42 with a large crushing amount. By increasing the crushing amount of the bump 42, even in a case where the heights of the bumps 42 are uneven due to manufacturing variations, it is possible to apply the pressing force to all the bumps. That is, it is possible to reduce a risk of occurrence of bonding failures in some bumps with a relatively low height.

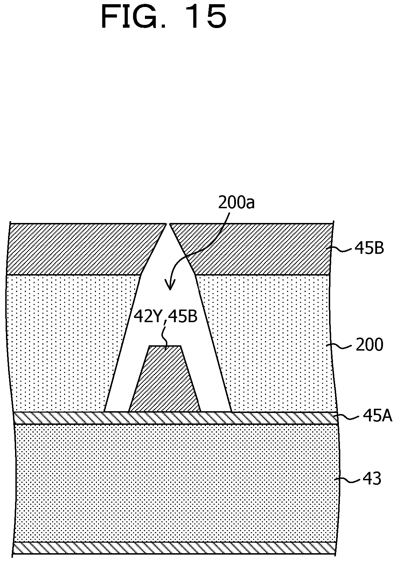

Here, FIG. 15 is a cross-sectional view illustrating an example of a method for forming a bump 42Y according to the comparative example. The bump 42Y according to the comparative example does not include the protrusion 44 according to the embodiment of the disclosed technology. That is, a portion to be a core of the bump 42Y does not include the base material 43, and includes only the conductive film 45B. The bump 42Y according to the comparative example is formed by a lift-off method using a resist 200 having an opening 200a with a high aspect ratio. That is, the conductive film 45B forming the bump 42Y is deposited on the conductive film 45A exposed from the opening 200a of the resist 200. However, with this method, before a bump with a sufficient height is formed, the fine opening 200a is closed by the conductive film 45B. As a result, it is difficult to form the bump with the high aspect ratio.

On the other hand, the bump 42 according to the embodiment of the disclosed technology includes the tapered protrusion 44 including the base material 43 of the second substrate 40 and the tapered conductive films 45A and 45B that cover the surface of the protrusion 44 and reflect the shape of the protrusion 44. That is, the portion to be the core of the bump 42 according to the embodiment of the disclosed technology includes the base material 43. The base material 43 is relatively easily micromachined into a desired shape, by an existing etching technique. By forming the portion to be the core of the bump 42 by the base material 43 of the second substrate 40, it is possible to easily form the fine bump 42 with the high aspect ratio having the tapered shape. Furthermore, by forming the portion to be the core of the bump 42 by the protrusion 44 of the base material 43, it is possible to make the protrusion 44 function as a stopper that prevents the bump 42 from being excessively crushed. Furthermore, by providing the recess 46 around the protrusion 44, it is possible to secure the strength of the bump 42.

[Second Embodiment]

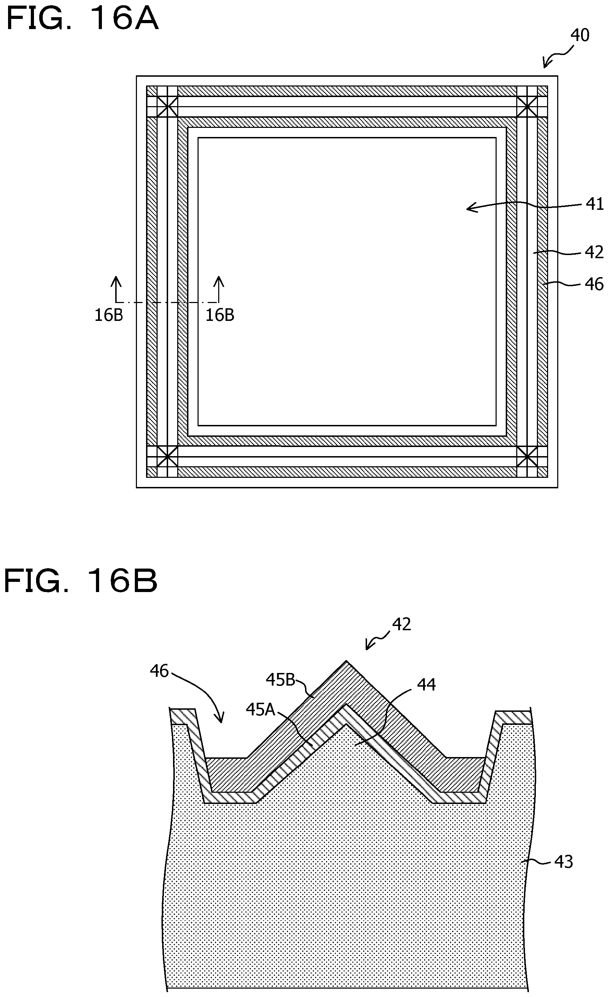

FIG. 16A is a plan view illustrating an example of a configuration of a second substrate 40 according to a second embodiment of the disclosed technology. FIG. 16B is a cross-sectional view taken along 16B-16B in FIG. 16A. The second substrate 40 according to the second embodiment is different from the first embodiment in a structure of a bump 42. A protrusion 44 including a base material 43 of the second substrate 40 according to the present embodiment has an integral annular structure portion surrounding a periphery of a cavity 41. That is, on the base material 43 of the second substrate 40, the protrusion 44 having a continuous rectangular coronal shape surrounding an outer periphery of a circuit element such as a qubit element 20 or a resonator 21 provided on a first substrate 30 is provided. The protrusion 44 has a tapered shape of which an area of a cross section intersecting with its height direction is gradually reduced toward a front end. A shape of a portion of the protrusion 44 forming one side of the coronal structure may be a quadrangular pyramid. Furthermore, the second substrate 40 includes a recess 46 provided around the protrusion 44. The recess 46 is provided in a coronal shape along a coronal structure of the protrusion 44.

According to a quantum operation device according to the present embodiment, it is possible to suppress bonding failures of the bump, similarly to the quantum operation device 10 according to the first embodiment. Furthermore, the bump 42 has the integrated annular structure so that a space around the qubit element 20 and the resonator 21 can be sealed. By evacuating this space, adsorption of a substance to the qubit element 20 can be prevented without forming a protection film that causes a dielectric loss on a surface of the qubit element 20.

[Third Embodiment]

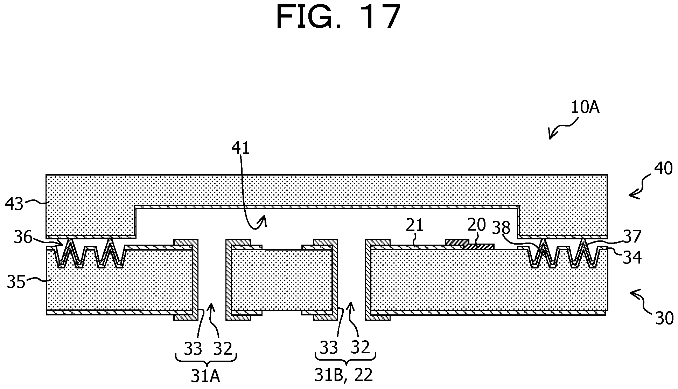

FIG. 17 is a cross-sectional view illustrating an example of a configuration of a quantum operation device 10A according to a third embodiment of the disclosed technology. The quantum operation device 10A according to the third embodiment is different from the quantum operation device 10 according to the first and second embodiments in that a bump 36 forming a bonding portion between a first substrate 30 and a second substrate 40 is provided on a first substrate 30. The bump 36 includes a tapered protrusion 38 that includes a base material 35 of the first substrate 30 and of which an area of a cross section intersecting with a lamination direction of the first substrate 30 and the second substrate 40 is gradually reduced toward a front end. The bump 36 includes tapered conductive films 34 and 37 that cover a surface of the protrusion 38 and reflect a shape of the protrusion 38. According to the quantum operation device 10A according to the third embodiment, it is possible to suppress bonding failures of the bump, similarly to the quantum operation device 10 according to the first embodiment.

In the first and second embodiments, a case has been described where the disclosed technology is applied to the quantum operation device 10 including the qubit element 20. However, the disclosed technology is not limited to this aspect. It is possible to apply the disclosed technology to an electronic device including a circuit element other than a superconducting device such as a transistor, a resistance element, or a capacitor.

CITATION LIST

PATENT DOCUMENT

Patent Document 1: U.S. Patent Application Publication No. 2020/0403138
Patent Document 2: U.S. Patent Application Publication No. 2020/0152540
Patent Document 3: U.S. Patent Application Publication No. 2019/0207075

REFERENCE SIGNS LIST

| | |
|---|---|
| 10 | quantum operation device |
| 20 | qubit element |
| 30 | first substrate |
| 35 | base material |
| 40 | second substrate |
| 36, 42, 42X, 42Y | bump |
| 43 | base material |
| 44 | protrusion |
| 34, 37, 45A, 45B | conductive film |

**Claims**

1. An electronic device comprising:

   a first substrate that includes a circuit element; and
   a second substrate that is laminated on the first substrate and covers the circuit element, wherein
   one of the first substrate and the second substrate includes
   a bump that includes a tapered protrusion that includes a base material of the substrate and of which an area of a cross section that intersects with a lamination direction of the first substrate and the second substrate is gradually reduced toward a front end, and a tapered conductive film that covers a surface of the protrusion and reflects a shape of the protrusion, and
   the bump is bonded to another one of the first substrate and the second substrate.

2. The electronic device according to claim 1, wherein the base material further includes a recess provided around the protrusion.

3. The electronic device according to claim 1 or 2, wherein
   the conductive film includes a plurality of laminated metal films.

4. The electronic device according to any one of claims 1 to 3, wherein

   the circuit element includes a qubit element, and
   the conductive film includes metal that exhibits superconductivity.

5. The electronic device according to any one of claims 1 to 4, wherein
   the protrusion has a conical shape or a pyramid shape.

6. The electronic device according to any one of claims 1 to 4, wherein
   the protrusion is formed in an annular shape so as to surround a periphery of the circuit element.

7. The electronic device according to any one of claims 1 to 6, wherein
   the conductive film covers an entire surface of the second substrate that faces the first substrate.

8. The electronic device according to any one of claims 1 to 7, wherein
   a front end of the bump protrudes from a surface of the base material of the second substrate.

9. The electronic device according to any one of claims 1 to 8, wherein
   an aspect ratio of the bump is equal to or more than two.

10. A method for manufacturing an electronic device, the method comprising:

    a process of producing a first substrate that includes a circuit element;
    a process of producing a second substrate that covers the circuit element; and
    a process of laminating the first substrate and the second substrate, wherein
    one of the process of producing the first substrate and the process of producing the second substrate includes a process of forming a bump on the substrate,
    the process of forming the bump includes
    a process of forming a tapered protrusion that includes a base material of the substrate and of which an area of a cross section that intersects with a lamination direction of the first substrate and the second substrate is gradually reduced toward a front end and
    a process of forming a tapered conductive film that covers a surface of the protrusion and reflects a shape of the protrusion, and
    in the process of laminating the first substrate and the second substrate, the bump is bonded to another one of the first substrate and the second substrate.

11. The manufacturing method according to claim 10, wherein
    the protrusion is formed by etching a region that corresponds to an outer periphery of the protrusion of the base material.

12. The manufacturing method according to claim 10 or 11, wherein
    the protrusion has a conical shape or a pyramid shape.

**13.** The manufacturing method according to claim 10 or 11, wherein
the protrusion is formed in an annular shape so as to surround a periphery of the circuit element.

**14.** The manufacturing method according to any one of claims 10 to 13, wherein
in the process of bonding the bump to the first substrate, the conductive film is deformed by applying a pressing force to the bump.

**15.** The manufacturing method according to any one of claims 10 to 14, wherein
the bump is bonded to the first substrate by room-temperature bonding between conductive films of which surfaces are activated by irradiation of an ion beam.

**16.** An electronic device comprising:

a bump that includes
a tapered protrusion that includes a base material of a substrate and of which an area of a cross section that intersects with a normal direction of the substrate is gradually reduced toward a front end and
a tapered conductive film that covers a surface of the protrusion and reflects a shape of the protrusion.

# FIG. 1

# FIG. 2

# FIG. 3

# FIG. 4

# FIG. 5

## FIG. 6A

## FIG. 6B

# FIG. 7

FIG. 8A

40

43

45A
45B
44
42

45A
45B
44
42

25

30

FIG. 8B

40

43

45A
45B
44
42

45A
45B
44
42

25

30

# FIG. 9

# FIG. 10

# FIG. 11A

43

# FIG. 11B

80b   80b
80a    80a                          80c                        L1
                                                          φ2    φ2
                                                          φ1    φ1    80

43

# FIG. 11C

φ3                              46    44
                                              D1
                                              43
φ4                              φ5

# FIG. 11D

81a
81                                                           81

43

FIG. 11E

41

43

FIG. 11F

45A

43

FIG. 11G

45B  82a  82a  45B          45B          82          45B  82a  82a  45B

82

45A          h

42  42          43

φ          42

5

FIG. 11H

40

## FIG. 12A

35

## FIG. 12B

83a   83a

S1

S2

83
35
90

## FIG. 12C

32   32

35

## FIG. 12D

S1

S2

34
35
34

# FIG. 12E

# FIG. 12F

# FIG. 12G

## FIG. 13A

ION BEAM

ION BEAM

## FIG. 13B

# FIG. 14A

42X

42X

MANUFACTURING
VARIATION

25X

# FIG. 14B

42X

25X

42X

BONDING FAILURE

# FIG. 15

## FIG. 16A

## FIG. 16B

# FIG. 17

## INTERNATIONAL SEARCH REPORT

International application No.

**PCT/JP2022/005649**

### A. CLASSIFICATION OF SUBJECT MATTER

***H01L 39/22***(2006.01)i; ***G06N 10/00***(2022.01)i; ***H01L 39/04***(2006.01)i
FI: H01L39/22 A; H01L39/04; G06N10/00

According to International Patent Classification (IPC) or to both national classification and IPC

### B. FIELDS SEARCHED

Minimum documentation searched (classification system followed by classification symbols)

H01L39/22; G06N10/00; H01L39/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2009-231721 A (TOPPAN PRINTING CO., LTD.) 08 October 2009 (2009-10-08) paragraphs [0037]-[0040], [0044]-[0047], [0052]-[0054], fig. 1, 3, 5 | 1, 2, 5, 6, 8-10, 12-14, 16 |
| Y | | 3, 11, 15 |
| A | | 4, 7 |
| Y | JP 2000-306952 A (NITTO DENKO CORP.) 02 November 2000 (2000-11-02) paragraph [0016], fig. 1 | 3 |
| Y | JP 2003-204162 A (DAINIPPON PRINTING CO., LTD.) 18 July 2003 (2003-07-18) paragraphs [0050]-[0058], fig. 2 | 11 |
| Y | WO 2005/097396 A1 (MATSUSHITA ELECTRIC INDUSTRIAL CO., LTD.) 20 October 2005 (2005-10-20) paragraph [0003] | 15 |
| A | WO 2020/169418 A1 (INTERNATIONAL BUSINESS MACHINES CORP.) 27 August 2020 (2020-08-27) | 1-16 |
| A | JP 11-163204 A (FUJITSU LTD.) 18 June 1999 (1999-06-18) | 1-16 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 April 2022** | **26 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

30

# EP 4 482 284 A1

International application No.

**PCT/JP2022/005649**

| Patent document cited in search report | | | Publication date (day/month/year) | Patent family member(s) | | | Publication date (day/month/year) |
|---|---|---|---|---|---|---|---|
| JP | 2009-231721 | A | 08 October 2009 | (Family: none) | | | |
| JP | 2000-306952 | A | 02 November 2000 | (Family: none) | | | |
| JP | 2003-204162 | A | 18 July 2003 | (Family: none) | | | |
| WO | 2005/097396 | A1 | 20 October 2005 | US<br>paragraph [0003]<br>CN | 2007/0193682<br><br>1942281 | A1<br><br>A | |
| WO | 2020/169418 | A1 | 27 August 2020 | US | 10692831 | B1 | |
| JP | 11-163204 | A | 18 June 1999 | US | 6329711 | B1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200403138
- US 20200152540
- US 20190207075